# EUROPEAN PATENT SPECIFICATION

(11) **EP 2 680 021 B1**
(45) Date of publication and mention of the grant of the patent: **04.03.2015**
(21) Application number: 13173080.6
(22) Date of filing: 20.06.2013
(51) Int. Cl.: G01R 33/09

(54) **Devices including tantalum alloy layers**
Vorrichtungen mit Tantallegierungsschichten
Dispositifs comprenant des couches d'alliage de tantale

(30) Priority: 25.06.2012 US 201261663721 P; 31.01.2013 US 201313755072
(43) Date of publication of application: 01.01.2014
(73) Proprietor: Seagate Technology LLC, Cupertino CA 95014 (US)
(72) Inventor: Singleton, Eric Walter, Maple Plain, MN 55359 (US); Tan, Liwen, Eden Prairie, MN 55347 (US); Yi, Jae-Young, Prior Lake, MN 55372 (US)
(74) Representative: Miller Sturt Kenyon

(56) References cited:
- WO-A1-2012/082998
- US-A- 5 268 806
- US-A1- 2003 063 415
- US-A1- 2009 122 450
- US-A1- 2012 161 263

## Description

### BACKGROUND

Currently utilized magneto-resistive devices, such as magneto-resistive heads for use in magnetic readers, utilize tantalum (Ta) as seed and cap layers in order to assist in the growth of magnetic layers. The mill rate of Ta can be lower than other materials in the stack leading to problems during the milling and lapping process. Therefore, there is a need for other materials for use in seed and/or cap layers.

WO 2012/082998 discloses a magnetic sensor having a bottom shield layer, an upper shield layer, and a sensor stack adjacent the upper shield layer. The sensor includes a seed layer between the bottom shield layer and an antiferromagnetic layer of the sensor stack. The seed layer has a magnetic layer adjacent the sensor stack and a nonmagnetic layer adjacent the bottom shield layer.

US 2003/063415 discloses a seed layer formed of a Cr film with a thickness of 15 Angstroms or more and 50 Angstroms or less comprising at least partially an amorphous phase.

US 2009/122450 discloses a high performance TMR sensor fabricated by employing a free layer comprised of CoBx with a lambda between -SxlO-6 and 0 on a MgOx tunnel barrier. Optionally, a FeCo/CoBx free layer configuration may be used where x is about 1 to 30 atomic %. Trilayer configurations represented by FeCo/CoFeB/CoBx, FeCo/CoBx/CoFeB, FeCoy/CoFeW/CoBx, or FeCoy/FeB/CoBx may also be employed. Alternatively, CoNiFeB or CoNiFeBM formed by cosputtering CoB with CoNiFe or CoNiFeM, respectively, where M is V, Ti, Zr, Nb, Hf, Ta, or Mo may be substituted for CoBx in the aforementioned embodiments.

US 2012/161263 discloses a current-perpendicular-to-the-plane (CPP) magnetoresistive (MR) sensor having a dual composition hard bias layer structure that is used to longitudinally bias the sensor's free ferromagnetic layer. The dual composition hard bias layer structure is composed of a first layer of CoPt, having high anisotropy compared to the second layer. The second layer, composed of CoFe, has a higher magnetization compared to the first layer.

US5268806 teaches the use of TaW as seed layer.

### SUMMARY

A device according to an aspect of the invention is defined in claim 1.

A magneto-resistive device according to another aspect of the invention is defined in claim 7.

These and various other features will be apparent from a reading of the following detailed description.

### BRIEF DESCRIPTION OF THE DRAWINGS

The disclosure may be more completely understood in consideration of the following detailed description of various embodiments of the disclosure in connection with the accompanying drawings, in which:
FIG. 1 provides a side view of an embodiment of a tunneling magneto-resistive sensor, in accordance with the present disclosure.
FIG. 2 shows the tunneling magneto-resistive (TMR) effect versus the minimum resistance for a magnetic stack having tantalum as a seed and cap layer and tantalum chromium as a seed and cap layer.
FIG. 3 shows the mill rate of various materials as a function of the mill angle.

The figures are not necessarily to scale. Like numbers used in the figures refer to like components. However, it will be understood that the use of a number to refer to a component in a given figure is not intended to limit the component in another figure labeled with the same number.

### DETAILED DESCRIPTION

In the following description, reference is made to the accompanying set of drawings that form a part hereof and in which are shown by way of illustration several specific embodiments. It is to be understood that other embodiments are contemplated and may be made without departing from the scope of the invention as defined by the claims. The following detailed description, therefore, is not to be taken in a limiting sense.

Unless otherwise indicated, all numbers expressing feature sizes, amounts, and physical properties used in the specification and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein.

The recitation of numerical ranges by endpoints includes all numbers subsumed within that range (e.g. 1 to 5 includes 1, 1.5, 2, 2.75, 3, 3.80, 4, and 5) and any range within that range.

As used in this specification and the appended claims, the singular forms "a", "an", and "the" encompass embodiments having plural referents, unless the content clearly dictates otherwise. As used in this specification and the appended claims, the term "or" is generally employed in its sense including "and/or" unless the content clearly dictates otherwise.

"Include," "including," or like terms means encompassing but not limited to, that is, including and not exclusive.

The present disclosure relates to magnetic stacks that include seed layers, cap layers, or both that are made of tantalum alloys. Such magnetic stacks can be utilized in or as tunneling magneto-resistive (TMR) sensors.

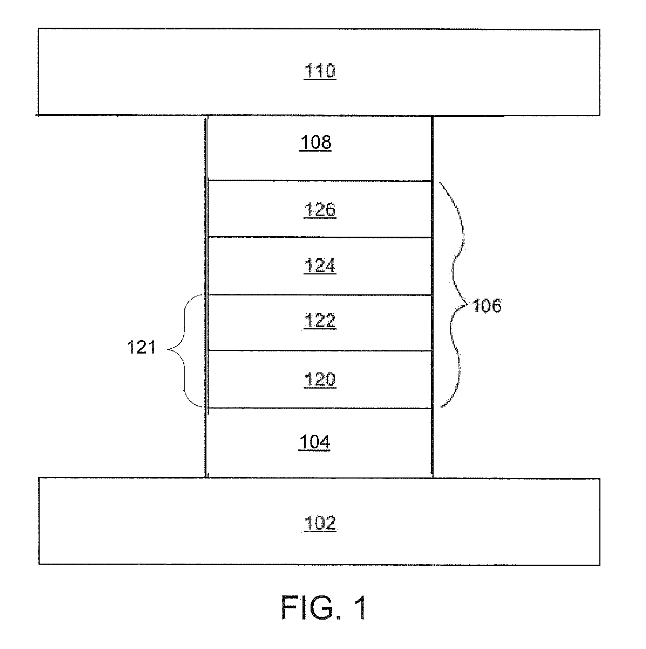

**FIG. 1** provides an embodiment of a magnetic device **100** (which can also be referred to as a stack, a magnetic stack or a magneto-resistive device) which can be utilized as a tunneling magneto-resistive (TMR) sensor. This magnetic device **100** can include a bottom shield **102,** a seed layer **104,** a sensor stack **106,** a cap layer **108,** and a top shield **110.** The sensor stack **106** can include, but is not limited to, a pinning layer **120,** a pinned layer **122** (in such an embodiment, the pinning layer **120** and the pinned layer **122** form the reference layer **121),** a barrier layer **124,** and a free layer **126.** Additional and optional layers, such as spacing and insulating layers can also be included in some embodiments of disclosed magnetic devices.

The sensor stack **106** is generally made of various magnetic and non-magnetic materials. For example, the free layer **126** can generally be a ferromagnetic material. Specific ferromagnetic materials that can be used can include, for example CoFe, CoFeB and NiFe. The barrier or spacer layer **124** is generally an insulating material. Specific insulating materials that can be used can include, for example MgO, Al₂O₃ Y₂O₃, CeO₂, TaO, SiN, AlN, CrO₂, HfO₂, ZrO₂ and TiO₂. In instances in which the sensor is to be a TMR sensor, this layer is a barrier layer and in other instances, it is a spacer layer. The pinned layer **122** is generally a ferromagnetic material. Specific ferromagnetic materials that can be used can include, for example CoFe and CoFeB. The pinning layer **120** is generally an antiferromagnetic material. Specific antiferromagnetic materials that can be used can include, for example PtMn, IrMn, NiMn and FeMn. It should also be noted that the sensor stack **106** can be configured to be something other than a tunneling magneto resistance (TMR) sensor. For example, the sensor stack **106** could be configured so that it functions as a giant magneto resistant (GMR) sensor, for example a current perpendicular to plane (CPP) sensor.

During manufacturing and processing of such disclosed magnetic devices, stacks including at least some of the disclosed structures can be subjected to ion milling steps. In magnetic devices that do not utilize tantalum alloys as a seed layer, cap layer, or both, differences in the rate of milling between the materials of the sensor stack and the seed/cap layers can result in magnetic devices that have issues. For example, if the seed and/or cap layers are made of materials that have much lower mill rates than the materials of the sensor stack, longer side mills must be utilized, which can introduce damage to the sensor stack as a thicker, magnetic or electrically dead layer. As requirements for areal density increase, shield to shield spacing (SSS) and reader width (RW) have to be scaled down; issues caused by differences in mill rates could make it difficult if not impossible to scale these dimensions down.

Disclosed herein therefore are magnetic devices that include seed layers, cap layers, or both that are made of tantalum alloys. In some embodiments, the seed layers, cap layers, or both can be a single layer. In some embodiments, the seed layers, cap layers, or both, are not bi-layer structures that include a second layer designed to orient the crystal structure of layers built thereon. In some embodiments, the seed layers, cap layers, or both, are not bi-layer structures that include a second layer made of a non-magnetic nickel alloy. In some embodiments, disclosed seed layers, cap layers, or both can however be utilized in combination with other layers. For example other layers of electrically conducting material, such as ruthenium (Ru). For example, a disclosed see layer, cap layer or both can be utilized adjacent to a layer of Ru (or other material).

In some embodiments, the tantalum alloys can be amorphous. Amorphous layers may enhance the growth of layers that may be formed thereon. Specific tantalum alloys that can be used can include, for example, TaX, where X can be Cr, V, Ti, Zr, Nb, Mo, Hf, W, or combinations thereof. In some embodiments, tantalum alloys can include, for example TaX, where X can be V, Ti, Zr, Nb, Mo, Hf, W, or combinations thereof. In some embodiments, a specific tantalum alloy can include TaCr.

The amounts of the various components (two elements in a binary alloy or three elements in a ternary alloy) can vary. The amount of the elements in an alloy can be chosen, at least in part, based on the desired structure of the alloy (the amounts of the elements can play a role in determining whether the alloy is amorphous, crystalline, or some combination thereof), the effect of the alloy on the magnetic properties of the device, physical properties of the alloy (hardness, etc.), other factors not discussed herein, or combinations thereof.

In some embodiments, the amount of Ta in TaX, where X can represent one or more than one elements, can range from 20 atomic % (at %) to 99 at%. In some embodiments, the amount of Ta in TaX, where X can represent one or more than one elements, can range from 40 at% to 80 at%. In some embodiments, the amount of Ta in TaX, where X can represent one or more than one elements, can range from 50 at% to 70 at%. In some embodiments, the amount of X in TaX, where X can represent one or more than one elements, can range from 1 at % to 80 at%. In some embodiments, the amount of X in TaX, where X can represent one or more than one elements, can range from 20 at% to 60 at%. In some embodiments, the amount of X in TaX, where X can represent one or more than one elements, can range from 30 at% to 50 at%. In some embodiments, the amount of X in TaX, where X is Cr, can range from 1 at % to 80 at%. In some embodiments, the amount of X in TaX, where X is Cr, can range from 20 at% to 60 at%. In some embodiments, the amount of X in TaX, where X is Cr, can range from 30 at% to 50 at%.

In some embodiments, only one of the seed layer or cap layer is made of a tantalum alloy. In some embodiments, both the seed layer and the cap layer are made of a tantalum alloy. In some embodiments, both the seed layer and the cap layer are made of a tantalum alloy, and the tantalum alloy in the seed layer and the cap layer are the same. In some embodiments, both the seed layer and the cap layer are made of a tantalum alloy, and the tantalum alloy in the seed layer and the cap layer are different, either in the identity of the components, the amount of the components, or a combination thereof. The materials to be used in the seed layer, the cap layer, or both can be chosen at least in part, based on their mill rates and the final configuration of the desired structure.

The present disclosure is illustrated by the following examples. It is to be understood that the particular examples, materials, amounts, and procedures are to be interpreted broadly in accordance with the scope of the invention as defined by the claims.

### EXAMPLES

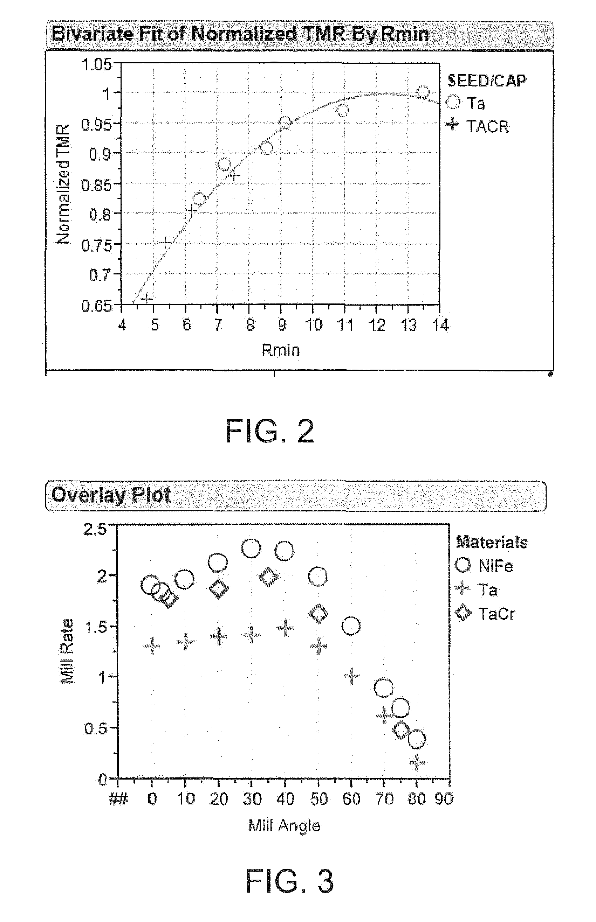

Magnetic stacks similar to that disclosed in **FIG. 1** were formed. The first stack utilized tantalum (Ta) as the seed layer and the cap layer. The second stack utilized a tantalum chromium (TaCr) alloy having 40 at% of Cr. **FIG. 2** shows the tunneling magneto-resistive (TMR) effect versus the minimum resistance (RMIN) of the two stacks. As seen there, the stack that included TaCr performed as well as the stack that utilized Ta, in that the TMR was not degraded.

**FIG. 3** shows the mill rate of various materials (NiFe, Ta, and TaCr- 40 at% Cr) as a function of the mill angle. As seen there, TaCr has a much higher mill rate than Ta (about 40% higher), and is quite close to the mill rate of NiFe.

Thus, embodiments of devices including tantalum alloy layers are disclosed. The implementations described above and other implementations are within the scope of the following claims. One skilled in the art will appreciate that the present disclosure can be practiced with embodiments other than those disclosed. The disclosed embodiments are presented for purposes of illustration and not limitation.

## Claims

1. A device comprising:
a sensor stack (106), the sensor stack comprising a reference layer (121), a free layer (126) and a barrier layer (124) positioned between the reference layer and the free layer;
a seed layer (104); and
a cap layer (108),
wherein the sensor stack is positioned between the seed layer and the cap layer, and wherein at least one of the seed layer and the cap layer comprises TaX, wherein X is selected from V, Ti, Zr, Nb, Mo, Hf, or a combination thereof.

2. The device according to claim 1, wherein the seed layer (104) and the cap layer (108) are amorphous.

3. The device according to claim 1 or claim 2, wherein the seed layer (104) comprises TaX, wherein X is selected from V, Ti, Zr, Nb, Mo, Hf, or a combination thereof.

4. The device according to any one of the preceding claims, wherein the cap layer (108) comprises TaX, wherein X is selected from V, Ti, Zr, Nb, Mo, Hf, W, or a combination thereof.

5. The device according to any one of the preceding claims, wherein both the seed layer (104) and the cap layer (108) independently comprise TaX, wherein X is selected from V, Ti, Zr, Nb, Mo, Hf, W, or a combination thereof.

6. The device according to any one of the preceding claims wherein the sensor stack is positioned adjacent the seed layer and the cap layer is positioned adjacent the sensor stack

7. A magneto-resistive device comprising:
a bottom shield (102);
the device according to any one of the preceding claims, the seed layer (121) being positioned adjacent the bottom shield (102); and
a top shield (110) positioned adjacent the cap layer (108).

## Patentansprüche

1. Vorrichtung mit:
einem Sensorstapel (106), wobei der Sensorstapel eine Referenzschicht (121), eine freie Schicht (126) und eine Sperrschicht (124) aufweist, die zwischen der Referenzschicht und der freien Schicht angeordnet ist;
einer Saatschicht (104); und
einer Deckschicht (108),
wobei der Sensorstapel zwischen der Saatschicht und der Deckschicht angeordnet ist und wobei mindestens eine Schicht von der Saatschicht und der Deckschicht TaX enthält, wobei X ausgewählt ist aus V, Ti, Zr, Nb, Mo, Hf oder einer Kombination derselben.

2. Vorrichtung nach Anspruch 1, wobei die Saatschicht (104) und die Deckschicht (108) amorph sind.

3. Vorrichtung nach Anspruch 1 oder 2, wobei die Saatschicht (104) TaX enthält, wobei X ausgewählt ist aus V, Ti, Zr, Nb, Mo, Hf oder einer Kombination derselben.

4. Vorrichtung nach einem der vorhergehenden Ansprüche, wobei die Deckschicht (108) TaX enthält, wobei X ausgewählt ist aus V, Ti, Zr, Nb, Mo, Hf, W oder einer Kombination derselben.

5. Vorrichtung nach einem der vorhergehenden Ansprüche, wobei sowohl die Saatschicht (104) als auch die Deckschicht (108) unabhängig voneinander TaX enthalten, wobei X ausgewählt ist aus V, Ti, Zr, Nb, Mo, Hf, W oder einer Kombination derselben.

6. Vorrichtung nach einem der vorhergehenden Ansprüche, wobei der Sensorstapel angrenzend an die Saatschicht angeordnet ist und die Deckschicht angrenzend an den Sensorstapel angeordnet ist.

7. Magnetoresistive Vorrichtung mit:
einer Unterseitenabschirmung (102);
der Vorrichtung nach einem der vorhergehenden Ansprüche, wobei die Saatschicht (121) angrenzend an die Unterseitenabschirmung (102) angeordnet ist; und
einer Oberseitenabschirmung (110), die angrenzend an die Deckschicht (108) angeordnet ist.

## Revendications

1. Dispositif comprenant :
un empilement de capteurs (106), l'empilement de capteurs comprenant une couche de référence (121), une couche libre (126) et une couche de barrière (124) positionnée entre la couche de référence et la couche libre ;
une couche de germe (104) ; et
une couche de recouvrement (108),
dans lequel l'empilement de capteurs est positionné entre la couche de germe et la couche de recouvrement, et dans lequel au moins l'une de la couche de germe et de la couche de recouvrement comprend TaX, où X est sélectionné parmi V, Ti, Zr, Nb, Mo, Hf ou une combinaison de ceux-ci.

2. Dispositif selon la revendication 1, dans lequel la couche de germe (104) et la couche de recouvrement (108) sont amorphes.

3. Dispositif selon la revendication 1 ou 2, dans lequel la couche de germe (104) comprend TaX, où X est sélectionné parmi V, Ti, Zr, Nb, Mo, Hf ou une combinaison de ceux-ci.

4. Dispositif selon l'une quelconque des revendications précédentes, dans lequel la couche de recouvrement (108) comprend TaX, où X est sélectionné parmi V, Ti, Zr, Nb, Mo, Hf, W ou une combinaison de ceux-ci.

5. Dispositif selon l'une quelconque des revendications précédentes, dans lequel à la fois la couche de germe (104) et la couche de recouvrement (108) comprennent indépendamment TaX, où X est sélectionné parmi V, Ti, Zr, Nb, Mo, Hf, W ou une combinaison de ceux-ci.

6. Dispositif selon l'une quelconque des revendications précédentes, dans lequel l'empilement de capteurs est positionné adjacent à la couche de germe et la couche de recouvrement est positionnée adjacente à l'empilement de capteurs.

7. Dispositif magnétorésistif comprenant :
un bouclier inférieur (102) ;
le dispositif selon l'une quelconque des revendications précédentes, la couche de germe (121) étant positionnée adjacente au bouclier inférieur (102) ; et
un bouclier supérieur (110) positionné adjacent à la couche de recouvrement (108).
